(19) Europäisches Patentamt
European Patent Office
Office européen des brevets

(11) **EP 0 780 496 B1**

(12) **EUROPÄISCHE PATENTSCHRIFT**

(45) Veröffentlichungstag und Bekanntmachung des Hinweises auf die Patenterteilung:
**15.03.2000 Patentblatt 2000/11**

(51) Int Cl.$^7$: **C30B 7/00**, C30B 29/34

(21) Anmeldenummer: **96118950.3**

(22) Anmeldetag: **27.11.1996**

(54) **Vorrichtung zur Züchtung von Zeolithkristallen aus einer wässrigen Lösung**

Apparatus for growing zeolite crystals from an aqueous solution

Appareillage pour la croissance de cristaux de zéolites à partir d'une solution aqueuse

(84) Benannte Vertragsstaaten:
**DE FR GB NL**

(30) Priorität: **23.12.1995 DE 19548742**

(43) Veröffentlichungstag der Anmeldung:
**25.06.1997 Patentblatt 1997/26**

(73) Patentinhaber: DORNIER GmbH
**88039 Friedrichshafen (DE)**

(72) Erfinder:
• **Stenzel, Christian, Dr.rer.nat.**
  **88048 Friedrichshafen (DE)**
• **Lenski, Harald, Dr.rer.nat.**
  **88662 Überlingen (DE)**

• **Wiesbeck, Werner, Prof. Dr.-Ing.**
  **75210 Keltern-Ellmendingen (DE)**
• **Demmerle, Frank, Dipl.-Ing.**
  **76131 Karlsruhe (DE)**

(56) Entgegenhaltungen:
  **DE-A- 4 102 233        DE-A- 4 113 042**
  **US-A- 4 778 666**

• **ZEOLITES, Bd. 13, März 1993, LONDON GB, Seiten 162-165, XP000645783 ARAFAT: "microwave preparation of zeolite Y and ZSM-5"**
• **CHEMISTRY OF MATERIALS, Bd. 2, Nr. 6, November 1990, WASHINGTON US, Seiten 712-719, XP000162366 DAVIS ET AL.: "Growth of Zeolite Crystallites and Coatings on Metal Surfaces"**

EP 0 780 496 B1

## Beschreibung

Die Erfindung betrifft eine Vorrichtung zur Züchtung von Zeolithkristallen aus einer wässrigen Lösung nach dem Oberbegriff des Anspruch 1.

Zeolithe sind anorganische Kristalle mit einer nach außen hin offenen Poren- oder Kanalstruktur, welche vielseitige industrielle Anwendungen ermöglicht. Zeolithe finden Einsatz als Katalysatoren in der petrochemischen Industrie, als Zusätze für Waschmittel, und aus Zeolithkristallen werden Molekularsiebe, Höchstleistungssensoren und Mikrofilter hergestellt. Sie dienen weiterhin als Ionentauscher in Anwendungen zur effizienteren Reinigung von Wasser und zur Entsorgung von radioaktivem Abfall.

Die herkömmliche Methode zur Herstellung im Labor ist die Kristallisation aus der wässrigen Lösung.

### Experimentelle Anforderungen:

Für die optimale Kristallisation von Zeolithkristallen aus einer wässrigen Lösung ist es erforderlich, das Volumen der Lösung schnell (innerhalb von Sekunden) und örtlich gleichförmig aufzuheizen. Bei der Temperatur von 180 °C wird die Lösung bis zu 30 Minuten gehalten und dann wieder abgekühlt auf Umgebungstemperatur.

Um ein Sieden der Lösung bei 180 °C zu vermeiden, ist ein Druck von ca. 15 bar in der Zelle erforderlich.

### Stand der Technik

Die Anforderung nach einer schnellen und gleichförmigen Heizung der wässrigen Zeolithlösung ist nur über den Einsatz von Mikrowellen zu realisieren. Konventionell beheizte Widerstandsöfen benötigen Stunden für die Aufheizung, es wird weiterhin nur der äußere Rand der Probe direkt beheizt, der Wärmetransport in das Innere geschieht mit einem gewissen Zeitverzug über thermische Konvektion und Wärmeleitung.

Die Kristallisation mit Hilfe einer Mikrowellenheizung wurde erst vor einigen Monaten entwickelt und getestet, erste vielversprechende Ergebnisse liegen vor (I. Girnus et al., Adv. Mater. 1995, 7, No. 8, p. 711; A. Arafat et al., ZEOLITES, 1993, Vol. 13, p. 162). In beiden Fällen wurde eine gepulste MW-Anlage mit Modenmixing benutzt, über die Homogenität der Temperaturverteilung ist nichts berichtet. Bei Girnus et al. erfolgt die Kristallisation ohne Druckbeaufschlagung. Bei Arafat et al. wurde ein mit einem Druckstempel versehenes Gefäß, in welchem sich die Zeolithlösung befand, in einen konventionellen Mikrowellenherd angeordnet.

Eine erste, eigene Messung der dielektrischen Konstanten $\varepsilon'$ und $\varepsilon''$ einer Zeolite A-Lösung bei Raumtemperatur und für eine Frequenz von 2,45 GHz ergab folgende Werte:

$$\varepsilon' = \varepsilon_0 \, (\varepsilon' - i\varepsilon'')$$

$$\tan \delta = \varepsilon''/\varepsilon'$$

Zeolite A:     $\tan \delta = 2{,}36$
(Wasser:      $\tan \delta = 0{,}16$)
(Teflon:      $\tan \delta = 0{,}002$)

Im Vergleich zu reinem Wasser ergibt sich somit ein um den Faktor 15 höherer Verlustfaktor, das heißt, die Zeolithlösung verhält sich wie ein elektrisch schlecht leitendes Material. Das direkte Einstrahlen von Mikrowellen bewirkt somit nur eine Aufheizung des äusseren Randes und nicht eine volumetrische Erwärmung der Lösung, die Forderung nach einer gleichförmigen Heizung kann somit mit diesem Verfahren nicht erfüllt werden.

Auf dem Gebiet der Erwärmung von Flüssigkeiten ist es bekannt (DE 41 02 233 A1, US 38 12 315, Stuwe: Konventionelle und dielektrische Erwärmung von Honig, in: Elektrowärme International, Nr. 8, 1968, S. 284 bis 291), daß sich eine gleichmäßige Erwärmung dadurch erreichen läßt, daß die Flüssigkeit in ein zwischen zwei Kondensatorplatten vorhandenes hochfrequentes, bzw. im Mikrowellenbereich gelegenes elektrisches Feld gebracht wird. Die Erwärmung erfolgt hierbei ohne Druckbeaufschlagung der Flüssigkeit.

Aufgabe der Erfindung ist es, eine Vorrichtung zur Züchtung von Zeolithkristallen aus einer wässrigen Lösung unter erhöhtem Druck und erhöhter Temperatur vorzuschlagen, mit der eine gleichförmige Aufheizung über das gesamte Volumen der zu erhitzenden Lösung möglich ist, wobei die Vorrichtung einen möglichst geringen Platz- und Raumbedarf aufweist.

Diese Aufgabe wird mit der Vorrichtung nach Anspruch 1 gelöst. Vorteilhafte Ausbildungen sind Gegenstände von Unteransprüchen.

Die erfindungsgemäße Vorrichtung umfaßt

- einen metallischen Druckbehälter zur Druckbeaufschlagung der wäßrigen Lösung sowie
- Mittel zur Zuführung von Mikrowellenenergie in die wäßrige Lösung,

wobei die Mittel zur Zuführung von Mikrowellenenergie (z.B. 2,45 GHz ) einen Kondensator umfassen, zwischen dessen Platten sich die zu erhitzende wäßrige Lösung befindet. Dabei ist eine der Kondensatorplatten von einer Wandung des Druckbehälters gebildet. Die andere Kondensatorplatte ist im Innern des Druckbehälters angeordnet.

Die elektrische Feldverteilung in einem Kondensator ist bis auf Randeffekte homogen, das Einbringen der Zeolithlösung bewirkt eine Änderung der Kapazität, jedoch keine Feldverzerrung.

Durch die erfindungsgemäße Integration von Kondensator und Druckbehälter wird eine äußerst kompakte und gut handhabbare Vorrichtung erhalten. Sie weist einen nur geringen Platz- und Raumbedarf auf.

Die erfindungsgemäße Vorrichtung eignet sich zur Züchtung von Zeolithkristallen an Bord eines Raumfahrzeuges oder auf der Erde.

Die Erfindung wird anhand eines Ausführungsbeispieles näher erläutert.

Es zeigen:

Fig. 1      eine erste Ausführung der erfindungsgemäßen Vorrichtung;

Fig. 2      eine weitere Ausführung der Erfindung in schematischer Darstellung;

Fig. 3      eine dritte Ausführung der Erfindung.

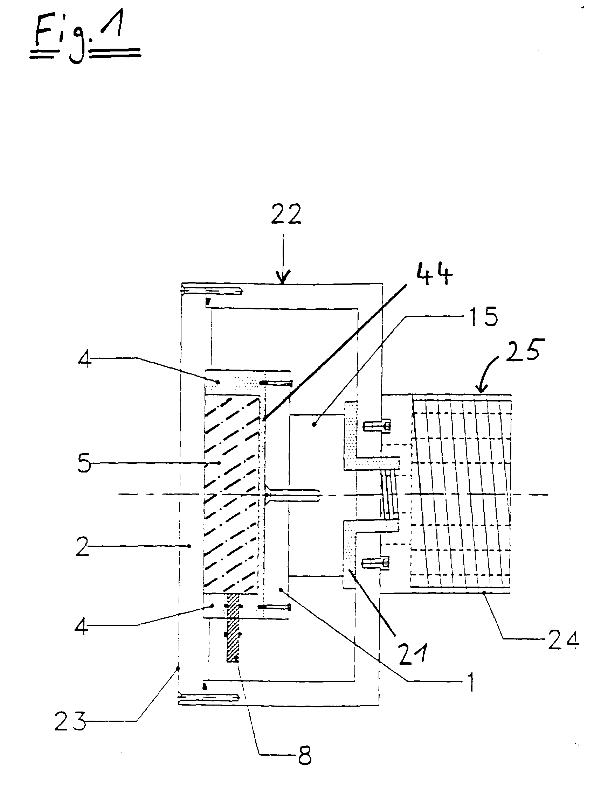

Fig. 1 zeigt eine erste Ausführung der erfindungsgemäßen Vorrichtung. Man erkennt einen Plattenkondensator mit den beiden Kondensatorplatten 1, 2. Sie bilden zusammen mit einer dielektrischen Wandung 4 (hier in Form eines Zylindermantels) eine Zelle, in der sich die zu erhitzende Lösung 5 befindet. Das Material der dielektrischen Wandung 4 muß thermisch isolierend sein. Um die Absorption von Mikrowellen durch die dielektrische Wandung 4 zu verhindern, sollte der Verlustfaktor tan δ deutlich unter 0,01 liegen. Geeignete Materialien für diesen Zweck sind Teflon und PEEK. In der dargestellten Ausführungsform ist die Wandung 4 der Zelle gleichzeitig die Wandung eines Topfs mit Topfboden 44, in dem die zu erhitzende Lösung 5 enthalten ist. Der Topfboden liegt an der Kondensatorplatte 1 an. Während des Prozesses muß das Auftreten von Blasen und Luftspalten in jedem Fall vermieden werden, da sich in diesem Fall die Kapazität lokal dramatisch ändert und demzufolge auch eine Feldverzerrung auftritt. Die Zelle aus Kondensatorplatten 1, 2 und dielektrischer Wandung 4 ist deshalb innerhalb eines z.B. zylinderförmigen Druckbehälters 22 angeordnet, innerhalb dessen ein Gasdruck von ca. 15 bar herrscht. Weiterhin muß der thermischen Ausdehnung der Lösung 5 bei Erhitzung auf 180 °C Rechnung getragen werden.

Dies wird durch eine bewegliche Stempeleinrichtung 8 gewährleistet. Diese ist radial an der dielektrischen Wandung 4 angeordnet. Eine Anordnung an den Kondensatorplatten 1, 2 ist zwar ebenfalls denkbar, jedoch weniger praktikabel, da die Kondensatorplatten fest montiert sein müssen, um eine optimale elektrische Ankopplung zu gewährleisten. Mit Hilfe dieses Konzeptes ist der Differenzdruck zwischen dem Innenraum des Druckbehälters 22 und der Lösung 5 innerhalb der Zelle zu jeder Zeit gleich Null.

Die Wände des Druckbehälters 22 sind aus Metall. Eine 2 der beiden Kondensatorplatten wird erfindungsgemäß durch den zentralen Bereich der stirnseitigen Behälterwandung 23 gebildet. Die ander Kondensatorplatte 1 befindet sich im Innern des Druckbehälters 22. Der Außenleiter 24 der Koaxialleitung 25 ist mit dem Druckbehälter 22 verbunden. Der Innenleiter 15 ist mit der Kondensatorplatte 1 im Innern des Druckbehälters 22 verbunden. Der Druckbehälter 22 bildet somit selbst ein Teil des Außenleiters. Die innere Zuleitung 15 ist komplett abgeschirmt durch den zylinderförmig ausgebildeten Druckbehälter 22. Dadurch ist das Streufeld im Druckbehälter 22 äußerst gering. Da der ganze Körper metallisch umschlossen ist, ist ebenfalls gewährleistet, daß keine elektromagnetischen Wellen austreten und die Umgebung beeinflussen. Die Teflonisolation 21 dient zur Isolierung des inneren Koaxialleiters 15 vom äußeren Koaxialleiter 22.

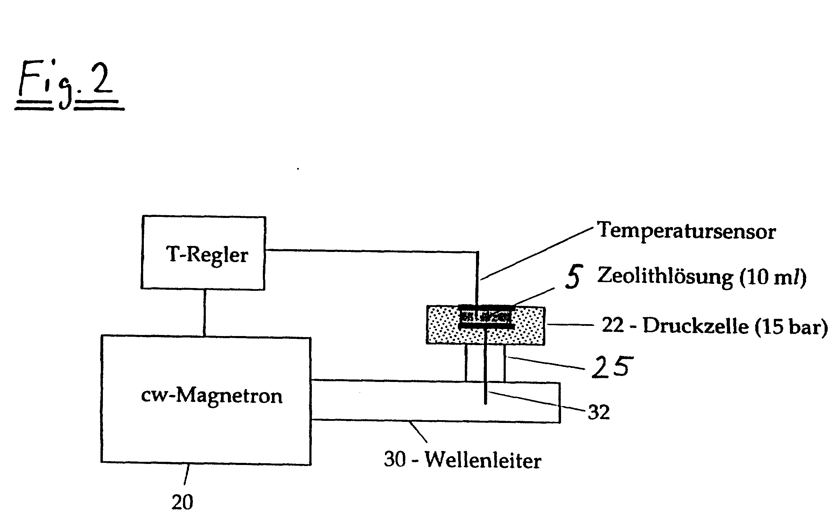

Fig. 2 zeigt die Gesamtkonfiguration einer erfindungsgemäßen Vorrichtung nach Fig. 1. Die Leistungsquelle ist ein regulierbares cw-Magnetron 20 mit einem kurzgeschlossenen Wellenleiterausgang. Der Wellenleiter 30 (Hohlleiter) muß dabei so dimensioniert sein, daß sich eine stehende Welle ausbildet. An einem Maximum des elektrischen Feldes innerhalb des Hohlleiters 30 ist ein konventioneller Koax-Stecker zum Auskoppeln des Feldes über die Antenne 32 angeordnet. Über die Koaxialleitung 25 wird die Mikrowellenfrequenz an die beiden Kondensatorplatten innerhalb des Druckbehälters 22 geführt. Der Aufbau von Kondensator und Druckzelle entspricht der in Fig. 1 dargestellten Ausführung. Zur Temperaturmessung ist ein gekapselter Thermosensor in die Zelle innerhalb des Druckbehälters 22 eingeklebt. Das Signal dieses Sensors stellt das Eingangssignal für die Kontrollschleife zur Temperaturregelung dar.

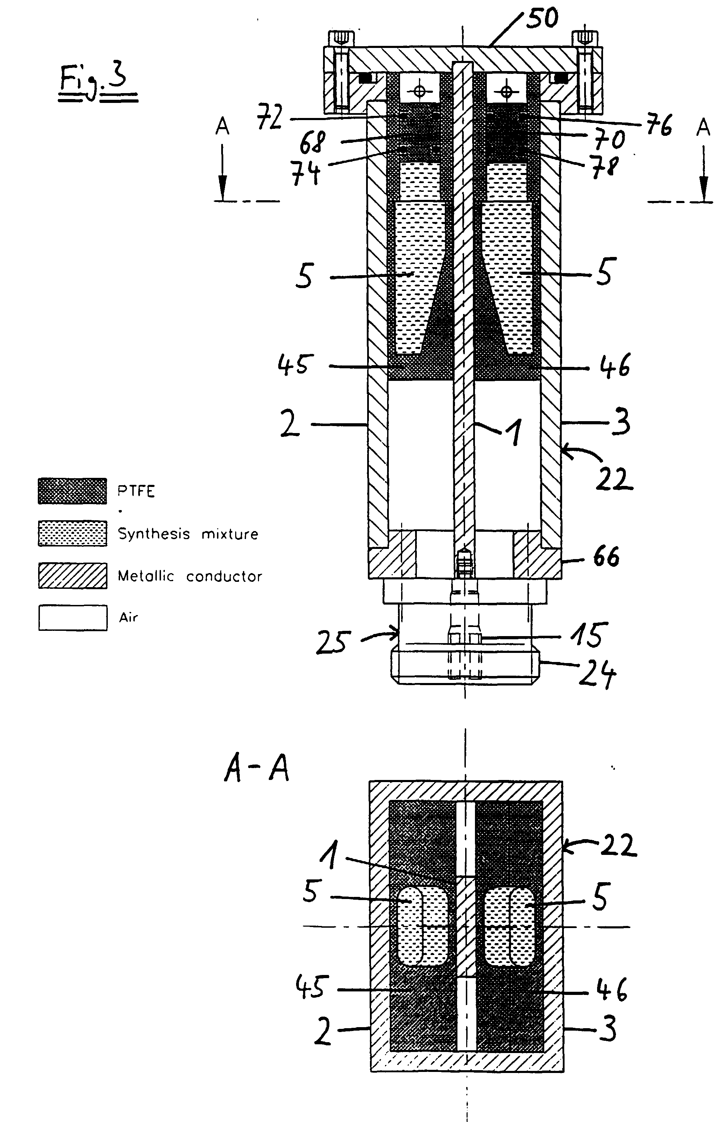

Eine weitere Ausführung der erfindungsgemäßen Vorrichtung zeigt Fig. 3 im Längsschnitt (oben) und Querschnitt (unten) entlang der Linie A-A. Der metallische Druckbehälter 22 weist hier einen rechteckigen Querschnitt auf. Er ist über den Flansch 66 mit dem Außenleiter 24 der Koaxialleitung 25 verbunden. Im Innern des Druckbehälters 22 und parallel zu dessen Seitenwänden 2,3 ist eine Kondensatorplatte 1 vorhanden, die mit dem Innenleiter 15 der Koaxialleitung 25 verbunden ist. In dieser Ausführung bilden somit die linke Wandung 2 des Druckbehälters 22 und die innenliegende Kondensatorplatte 1 einen ersten Kondensator und die rechte Wandung 3 des Druckbehälters 22 und die innenliegende Kondensatorplatte 1 einen zweiten Kondensator. Wie bei den Ausführungen nach Fig. 1 und 2 bildet auch hier der Druckbehälter 22 selbst einen Teil des Außenleiters der Koaxialleitung 25. Der Außenleiter 24 wird zweckmäßigerweise mit dem Flansch 66 verschweißt, so daß eine druckdichte Verbindung hergestellt wird.

Koaxialleitung 25 und Kondensatorplatten 1,2,3 sind in dieser Ausführung koaxial angeordnet.

Jeweils zwischen den Kondensatorplatten 1,2,3 befindet sich die zu erhitzende wäßrige Lösung 5, die innerhalb der Behälter 45,46 aus PTFE angeordnet ist. Für jeden Behälter ist ein mit O-Ringen 72, 74, 76, 78 abgedichteter, beweglicher Stempel 68, 70 zum Druckausgleich zwischen wäßriger Lösung 5 und dem Innern des Druckbehälters 22 vorhanden.

Die Form der Behälter **45**,**46** ist hier derart ausgeführt, daß der Anteil der wäßrigen Lösung in axialer Richtung mit zunehmendem Abstand von der Koaxialleitung **25** zunimmt. Deshalb wird auf der der Koaxialleitung **25** zugewandten Seite, an der das elektrische Feld am größten ist, ein relativ geringer Teil der Mikrowellenenergie absorbiert. An der der Grundseite **50** des Druckbehälters **22** zugewandten Seite dagegen, auf der das elektrische Feld abgeschwächt ist, wird ein größerer Anteil der Mikrowellenenergie absorbiert. Durch diese Geometrie der Flüssigkeitsbehälter **45**,**46** wird eine homogene Aufheizung über das gesamte Probenvolumen erreicht.

Vorteilhafte Eigenschaften dieser Erfindung sind:

- es ist ein nahezu homogenes elektrisches Feld im Bereich der zu erhitzenden Lösung vorhanden,
- eine wesentlich verringerte Empfindlichkeit des Eingangsreflektionsfaktors bezüglich Änderungen der komplexen Dielektrizitätszahl der Lösung während des Prozessierens im Vergleich zu Resonatoranordnungen,
- eine sehr gute Anpassung der Druckzelle für einen optimalen Leistungseintrag über die gesamte Aufheizzeit,
- eine einfache Ankopplung an axiale Leitungen,
- eine geringe Wärmeableitung und somit eine homogene Wärmeentwicklung in der Lösung bedingt durch die dielektrischen Wandungen der Zelle aus einem Material geringer Wärmeleitfähigkeit.

**Patentansprüche**

1. Vorrichtung zur Züchtung von Zeolithkristallen aus einer wäßrigen Lösung (**5**), umfassend

    - einem metallischen Druckbehälter (**22**), zur Druckbeaufschlagung der wäßrigen Lösung (**5**) sowie
    - Mittel zur Zuführung von Mikrowellenenergie in die wäßrige Lösung (**5**);

    **dadurch gekennzeichnet**, daß die Mittel zur Zuführung von Mikrowellenenergie einen Kondensator umfassen, zwischen dessen Platten (**1**,**2**) sich die wäßrige Lösung (**5**) befindet, wobei eine (**2**) der Kondensatorplatten von einer Wandung des Druckbehälters (**22**) gebildet ist und die andere Kondensatorplatte (**1**) im Innern des Druckbehälters (**22**) angeordnet ist.

2. Vorrichtung nach Anspruch 1, **dadurch gekennzeichnet**, daß die Mittel zur Zuführung von Mikrowellenenergie eine mit dem Kondensator verbundene Koaxialleitung (**25**) umfassen.

3. Vorrichtung nach einem der vorangehenden Ansprüche, **dadurch gekennzeichnet**, daß der Außenleiter (**24**) der Koaxialleitung (**25**) mit dem Druckbehälter (**22**) verbunden ist.

4. Vorrichtung nach einem der vorangehenden Ansprüche, **dadurch gekennzeichnet**, daß der Innenleiter (**15**) der Koaxialleitung (**25**) mit der im Innern des Druckbehälters (**22**) angeordneten Kondensatorplatte (**1**) verbunden ist.

5. Vorrichtung nach einem der vorangehenden Ansprüche, **dadurch gekennzeichnet**, daß die wäßrige Lösung (**5**) sich innerhalb eines dielektrischen Behälters (**44**,**45**,**46**) befindet.

6. Vorrichtung nach Anspruch 5, **dadurch gekennzeichnet**, daß der dielektrische Behälter (**44**,**45**,**46**) aus Teflon oder PEEK ist.

7. Vorrichtung nach einem der vorangehenden Ansprüche, **dadurch gekennzeichnet**, daß Mittel zum Druckausgleich zwischen dem Druckbehälter (**22**) und der zu erhitzenden Lösung (**5**) vorhanden sind.

8. Vorrichtung nach Anspruch 7, **dadurch gekennzeichnet**, daß die Mittel zum Druckausgleich durch einen beweglichen Stempel (**8**,**68**,**70**) gebildet werden.

9. Vorrichtung nach einem der vorangehenden Ansprüche, **dadurch gekennzeichnet**, daß die Koaxialleitung (**25**) und die Kondensatorplatten (**1**,**2**,**3**) koaxial zueinander angeordnet sind.

10. Vorrichtung nach einem der vorangehenden Ansprüche, **dadurch gekennzeichnet**, daß die Koaxialleitung (**25**) und die Kondensatorplatten (**1**,**2**,**3**) senkrecht zueinander angeordnet sind.

11. Vorrichtung nach einem der vorangehenden Ansprüche, **dadurch gekennzeichnet**, daß die im Innern des Druckbehälters (**22**) angeordnete Kondensatorplatte (**1**) zusammen mit einer weiteren Wandung des Druckbehälters (**22**) einen weiteren Kondensator bildet, zwischen dessen Platten (**1**,**3**) sich die wäßrige Lösung (**5**) befindet.

**Claims**

1. Device for growing zeolite crystals from an aqueous solution (5), comprising

    - a metal pressure vessel (22) for pressurizing the aqueous solution (5), and
    - means for delivering microwave energy to the aqueous solution (5);

characterized in that the means for delivering microwave energy comprise a capacitor, between whose plates (1, 2) the aqueous solution (5) is located, one (2) of the capacitor plates being formed by one wall of the pressure vessel (22) and the other capacitor plate (1) being arranged inside the pressure vessel (22).

2. Device according to Claim 1, characterized in that the means for delivering microwave energy comprise a coaxial cable (25) connected to the capacitor.

3. Device according to one of the preceding claims, characterized in that the outer conductor (24) of the coaxial cable (25) is connected to the pressure vessel (22) .

4. Device according to one of the preceding claims, characterized in that the inner conductor (15) of the coaxial cable (25) is connected to the capacitor plate (1) arranged inside the pressure vessel (22).

5. Device according to one of the preceding claims, characterized in that the aqueous solution (5) is located inside in a dielectric vessel (44, 45, 46).

6. Device according to Claim 5, characterized in that the dielectric vessel (44, 45, 46) is made of PTFE or PEEK.

7. Device according to one of the preceding claims, characterized in that there are means for equilibrating the pressure between the pressure vessel (22) and the solution (5) to be heated.

8. Device according to Claim 7, characterized in that the means for equilibrating the pressure are formed by a moving plunger (8, 68, 70).

9. Device according to one of the preceding claims, characterized in that the coaxial cable (25) and the capacitor plates (1, 2, 3) are arranged coaxial with each other.

10. Device according to one of the preceding claims, characterized in that the coaxial cable (25) and the capacitor plates (1, 2, 3) are arranged perpendicular with each other.

11. Device according to one of the preceding claims, characterized in that the capacitor plate (1) arranged inside the pressure vessel (22) forms, together with a further wall of the pressure vessel (22), a further capacitor between whose plates (1, 3) the aqueous solution (5) is located.

**Revendications**

1. Dispositif pour la croissance de cristaux de zéolites à partir d'une solution aqueuse (5), comprenant

   - un réservoir métallique sous pression (22), pour la pressurisation de la solution aqueuse (5), ainsi que
   - des moyens pour l'alimentation de la solution aqueuse (5) en énergie sous forme de micro-ondes,

   caractérisé en ce que les moyens pour l'alimentation en énergie sous forme de micro-ondes comprennent un condensateur, entre les plaques duquel (1, 2) se situe la solution aqueuse (5), l'une (2) des plaques du condensateur étant formée d'une paroi du réservoir sous pression (22) et l'autre plaque (1) de condensateur étant disposée à l'intérieur du réservoir sous pression (22).

2. Dispositif suivant la revendication 1, caractérisé en ce que les moyens pour l'alimentation en énergie sous forme de micro-ondes comprennent une ligne coaxiale (25) reliée au condensateur.

3. Dispositif suivant l'une des revendications précédentes, caractérisé en ce que le conducteur extérieur (24) de la ligne coaxiale (25) est relié au réservoir sous pression (22).

4. Dispositif suivant l'une des revendications précédentes, caractérisé en ce que le conducteur intérieur (15) de la ligne coaxiale (25) est relié à la plaque (1) de condensateur disposée à l'intérieur du réservoir sous pression (22).

5. Dispositif suivant l'une des revendications précédentes, caractérisé en ce que la solution aqueuse (5) se situe à l'intérieur d'un réservoir diélectrique (44, 45, 46).

6. Dispositif suivant la revendication 5, caractérisé en ce que le réservoir diélectrique (44, 45, 46) est en Téflon ou en polyétheréthercétone.

7. Dispositif suivant l'une des revendications précédentes, caractérisé en ce que des moyens d'équilibrage de pression se trouvent entre le réservoir sous pression (22) et la solution à chauffer (5).

8. Dispositif suivant la revendication 7, caractérisé en ce que les moyens d'équilibrage de pression sont formés par un piston mobile (8, 68, 70).

9. Dispositif suivant l'une des revendications précédentes, caractérisé en ce que la ligne coaxiale (25) et les plaques de condensateur (1, 2, 3) sont disposées de manière coaxiale l'une par rapport aux autres.

**10.** Dispositif suivant l'une des revendications précédentes, caractérisé en ce que la ligne coaxiale (25) et les plaques de condensateur (1, 2, 3) sont disposées perpendiculairement l'une par rapport aux autres.

**11.** Dispositif suivant l'une des revendications précédentes, caractérisé en ce que la plaque (1) du condensateur disposée à l'intérieur du réservoir sous pression (22) forme conjointement avec une autre paroi du réservoir sous pression (22) un autre condensateur, entre les plaques (1,3) duquel se situe la solution aqueuse (5).

Fig. 1

Fig. 2

# Fig.3

Legend:
- PTFE
- Synthesis mixture
- Metallic conductor
- Air

A-A